# EUROPEAN PATENT APPLICATION

(11) **EP 4 815 648 A1**
(43) Date of publication of application: **30.09.2026**
(21) Application number: 24906139.1
(22) Date of filing: 06.12.2024
(51) Int. Cl.: H05K 5/02

(54) **MOBILE TERMINAL AND HEAT DISSIPATION CONTROL METHOD THEREFOR**

(30) Priority: 18.12.2023 CN 202311749680
(71) Applicant: Huawei Technologies Co., Ltd., Shenzhen, Guangdong 518129 (CN)
(72) Inventor: HE, Zhen, Shenzhen, Guangdong 518129 (CN); NI, Yu, Shenzhen, Guangdong 518129 (CN); QIU, Jiahuan, Shenzhen, Guangdong 518129 (CN); WANG, Yeren, Shenzhen, Guangdong 518129 (CN)
(74) Representative: MERH-IP Matias Erny Reichl Hoffmann Patentanwälte PartG mbB
(86) International application number: PCT/CN2024/137336
(87) International publication number: WO 2025/130655

(57) **Abstract**

Embodiments of this application disclose a mobile terminal and a heat dissipation control method therefor, relating to the field of terminal device technologies, so that both heat dissipation performance and minimalist design and refinement of appearance of the mobile terminal can be achieved. The mobile terminal includes a housing, a display panel, a heat-generating component, a heat-dissipating apparatus, and an air duct. The housing includes a fixed housing and a heat-dissipating housing that are disposed on a non-display side of the display panel, and a support cover plate. The housing is provided with a plurality of first air inlets located in the heat-dissipating housing and a plurality of air outlets located in the heat-dissipating housing and/or the fixed housing. The air duct connects the plurality of first air inlets to the plurality of air outlets. The heat-generating component and the heat-dissipating apparatus are disposed in the air duct. The support cover plate is movably connected to the heat-dissipating housing and/or the fixed housing, and switches between a folded state and an unfolded state. The folded state is that the support cover plate covers the heat-dissipating housing and blocks at least a portion of the first air inlets. The unfolded state is that the support cover plate supports the display panel in an upright position and is moved away from the at least a portion of the first air inlets.

## Description

This application claims priority to Chinese Patent Application No. 202311749680.2, filed with the China National Intellectual Property Administration on December 18, 2023 and entitled "MOBILE TERMINAL AND HEAT DISSIPATION CONTROL METHOD THEREFOR", which is incorporated herein by reference in its entirety.

### TECHNICAL FIELD

This application relates to the field of terminal device technologies, and in particular, to a mobile terminal and a heat dissipation control method therefor.

### BACKGROUND

As consumers have increasingly high requirements for mobile office and entertainment, performance of mobile terminals such as notebook computers and tablet computers is continuously improved, and power consumption is increasingly high. To ensure heat dissipation performance of a mobile terminal, a plurality of air inlets and a plurality of air outlets need to be provided in a housing. However, in consideration of minimalist design and refinement of appearance of the mobile terminal, the plurality of air inlets and the plurality of air outlets cannot be provided in a surface of the housing of the mobile terminal, making it impossible to meet a heat dissipation requirement of the existing mobile terminal.

### SUMMARY

Embodiments of this application provide a mobile terminal and a heat dissipation control method therefor, so that both high heat dissipation performance and minimalist design and refinement of appearance of the mobile terminal can be achieved.

To achieve the foregoing objective, this application uses the following technical solutions.

According to a first aspect, an embodiment of this application provides a mobile terminal. The mobile terminal includes a housing, a display panel, a heat-generating component, a heat-dissipating apparatus, and an air duct. The housing may be specifically made of a material with good heat dissipation performance, for example, metal. The housing includes a fixed housing, a heat-dissipating housing, and a support cover plate. The fixed housing and the heat-dissipating housing are connected and disposed on a non-display side of the display panel. The display panel, the fixed housing, and the heat-dissipating housing define a mounting cavity. In addition, a plurality of first air inlets are provided in the heat-dissipating housing. A plurality of air outlets are further provided in the housing, and the plurality of air outlets may be located in the fixed housing, or may be located in the heat-dissipating housing, or may be located in the fixed housing and the heat-dissipating housing separately. The support cover plate is disposed on a side of the heat-dissipating housing away from the display panel. The air duct and the heat-dissipating apparatus are both disposed in the mounting cavity of the housing, and the air duct is configured to communicate the plurality of first air inlets with the air outlets. The heat-generating component is disposed in the air duct. The heat-dissipating apparatus directs external air to the heat-generating component in the air duct through the plurality of first air inlets for heat exchange, and then directs the heat-exchanged air out through the plurality of air outlets. For example, the heat-dissipating apparatus may be a heat-dissipating fan. In addition, the support cover plate is movably connected to the heat-dissipating housing or the fixed housing. Alternatively, the support cover plate is movably connected to the heat-dissipating housing and the fixed housing. The support cover plate switches between a folded state and an unfolded state. The folded state is that the support cover plate covers the heat-dissipating housing and can block at least a portion of the first air inlets of the heat-dissipating housing. The unfolded state is that the support cover plate supports the display display panel in an upright position and is moved away from the blocked first air inlets. The support cover plate supports the display panel in an upright position, thereby facilitating viewing of the display panel by a user.

It should be noted that when the support cover plate switches to the folded state, the mobile terminal may be in a low power state, and the heat-generating component generates less heat. When the support cover plate switches to the unfolded state, the mobile terminal may be in a high power state, and the heat-generating component generates more heat.

Compared with the existing technology, in this embodiment of this application, a portion of the housing of the mobile terminal is changed into the heat-dissipating housing and the support cover plate, the heat-dissipating housing and the fixed housing are connected to form an integrated structure and disposed on the non-display side of the display panel, to form the mounting cavity. The heat-generating component and the heat-dissipating apparatus may be mounted in the mounting cavity, to implement a function of the original housing. The plurality of first air inlets provided in the heat-dissipating housing are in communication with the plurality of air outlets through the air ducts in the housing. The support cover plate is movably connected to either or both of the heat-dissipating housing and the fixed housing. When the support cover plate moves or rotates relative to either or both of the heat-dissipating housing and the fixed housing, the support cover plate switches between the folded state and the unfolded state. When the mobile terminal is in a high-power consumption state, the support cover plate may switch to the unfolded state. In this case, the support cover plate supports the display panel in an upright position and is moved away from the plurality of blocked first air inlets. Therefore, the heat-dissipating apparatus may direct external air to enter the air duct of the housing through the plurality of first air inlets for heat exchange with the heat-generating component in the air duct, and then direct the air out of the air duct through the plurality of air outlets. The heat-dissipating apparatus may perform forced and efficient heat dissipation on the heat-generating component, and the heat dissipation performance for the heat-generating component is good. When the mobile terminal is in a low-power consumption state, the support cover plate may switch to the folded state. In this case, the support cover plate covers the heat-dissipating housing, and blocks some or all of the first air inlets in the heat-dissipating housing. In this case, heat dissipation may be performed on the heat-generating component through natural heat conduction (heat generated by the heat-generating component is conducted to the housing for heat dissipation) of the housing, or heat dissipation may be performed on the heat-generating component through natural heat conduction and the heat-dissipating apparatus operating at low power. Therefore, when the support cover plate is in the folded state, some or all of the first air inlets are blocked, thereby reducing a quantity of holes in a surface of the mobile terminal, and improving minimalist design and refinement of appearance of the mobile terminal. Therefore, the mobile terminal in this embodiment of this application can achieve both high heat dissipation performance and the minimalist design and refinement of the appearance of the mobile terminal.

In addition, in some embodiments of this application, some or all of the plurality of light outlets are located at positions on the heat-dissipating housing that are opposite to the support cover plate. Therefore, when the support cover plate is in the folded state, the support cover plate may block some or all of the air outlets (to be specific, some or all of the air outlets that are opposite to the support cover plate). Some or all of the air outlets may be blocked, thereby also improving the minimalist design and refinement of the appearance of the mobile terminal.

To implement that a controller reduces rotational speed of the heat-dissipating fan to dissipate heat for the heat-generating component when the mobile terminal is in the low-power consumption state, in some embodiments of this application, the mobile terminal further includes a heat-conducting apparatus. The heat-conducting apparatus may be disposed in the mounting cavity and in contact with the heat-generating component and the housing separately. Therefore, the heat-conducting apparatus may transfer heat generated by the heat-generating component to the housing, and the housing exchanges heat with external air, thereby implementing natural heat dissipation for the heat-generating component. For example, when the mobile terminal is in the low-power consumption state, the support cover plate may switch to the folded state. In this case, the heat-conducting apparatus can dissipate heat for the heat-generating component, thereby ensuring heat dissipation performance of the mobile terminal. The heat-conducting apparatus may be specifically a heat-conducting pipe.

Similarly, in some implementations of this application, the foregoing mobile terminal further includes a heat-spreading apparatus, and the heat-spreading apparatus is disposed in the mounting cavity and in contact with the heat-generating component and the housing. The heat-spreading apparatus may spread and move heat generated by the heat-generating component in an entire plane and conduct the heat to the housing for heat dissipation. The heat-spreading apparatus avoids local overheating, thereby improving a heat dissipation effect for the heat-generating component. For example, when the mobile terminal is in the low-power consumption state, the support cover plate may switch to the folded state. In this case, the heat-spreading apparatus spreads heat for various heat-generating components, thereby ensuring that no region of a tablet computer is overheated. The heat-spreading apparatus may be specifically a heat-spreading sheet or a heat-spreading plate.

Based on the foregoing structure, in some embodiments of this application, the foregoing mobile terminal further includes a driving member, and the driving member is drivingly connected to the support cover plate. The driving member is configured to drive the support cover plate to switch between the folded state and the unfolded state, to implement automatic unfolding and folding of the support cover plate.

For example, the driving member is a driving motor. The support cover plate is rotatably connected to the heat-dissipating housing by a hinge shaft, for example. The support cover plate is fastened to the hinge shaft. An output shaft of the driving motor is drivingly connected to the hinge shaft. Therefore, the driving motor drives the hinge shaft to rotate, and drives the support cover plate to unfolded (namely, in the unfolded state) or fold (namely, in the folded state).

In addition, in some implementations, the foregoing mobile terminal further includes a controller, and the controller is electrically connected to the driving member. The controller is configured to: when the driving member feeds back that the support cover plate is in the folded state, control the heat-dissipating apparatus to turn off or reduce operating power of the heat-dissipating apparatus (for example, reduce the rotational speed of the heat-dissipating fan). In this case, the heat-generating component of the mobile terminal may be in the low-power consumption state, and the heat-generating component may use only the heat-conducting apparatus and the heat-spreading apparatus for heat dissipation. Alternatively, the heat-conducting apparatus, the heat-spreading apparatus, and the heat-dissipating fan operating at low rotational speed may be used to perform heat dissipation. Therefore, in this embodiment of this application, when being in the low-power consumption state, the mobile terminal may automatically switch to natural heat exchange (to be specific, the heat-conducting apparatus and the heat-spreading apparatus perform heat dissipation) or a low-rotational speed air-cooled heat dissipation (to be specific, the heat-dissipating fan operating at low rotational speed performs heat dissipation) manner to perform heat dissipation. Therefore, the heat dissipation performance is good, and the minimalist design and refinement of the appearance of the mobile terminal are achieved.

The controller is further configured to: when the driving member feeds back that the support cover plate is in the unfolded state, control the heat-dissipating apparatus to turn on or increase operating power of the heat-dissipating apparatus (for example, increase the rotational speed of the heat-dissipating fan). In this case, the heat-generating component of the mobile terminal may be in the high-power consumption state, the plurality of first air inlets are not blocked, and the heat-conducting apparatus, the heat-spreading apparatus, and the heat-dissipating fan operating at high rotational speed may be used to perform heat dissipation. Therefore, in this embodiment of this application, when being in the high-power consumption state, the mobile terminal may automatically switch to a manner combining high-rotational speed forced air-cooled heat dissipation with natural heat exchange for heat dissipation, and the heat dissipation performance is good.

In some other embodiments of this application, the support cover plate may alternatively switch between states in a manual manner. Therefore, to implement the foregoing functions, the foregoing mobile terminal further includes a detection apparatus, where the detection apparatus is configured to detect a status of the support cover plate. For example, the detection apparatus may be an angle sensor or a distance sensor. The controller may control on or off of the heat-dissipating apparatus or adjust the operating power of the heat-dissipating apparatus based on the status of the support cover plate detected by the detection apparatus. To be specific, the controller is configured to: when the detection apparatus detects that the support cover plate is in the folded state, control the heat-dissipating apparatus to turn off or reduce the operating power of the heat-dissipating apparatus (for example, reduce the rotational speed of the heat-dissipating fan) to perform heat dissipation; and when the detection apparatus detects that the support cover plate is in the unfolded state, control the heat-dissipating apparatus to turn on or increase the operating power of the heat-dissipating apparatus (for example, increase the rotational speed of the heat-dissipating fan).

The foregoing describes a heat-dissipating structure in the mobile terminal and switching of heat dissipation manners. It should be noted that in this embodiment of this application, there may be a plurality of distribution manners of the plurality of first air inlets. For example, an outer surface of the heat-dissipating housing includes a first side surface, a second side surface, and a first surface. The support cover plate covers the first surface. The first side surface may be disposed opposite to the second side surface. A portion of the plurality of first air inlets is distributed on the first surface, and the remainder of the plurality of first air inlets are distributed on the first side surface and the second side surface separately. When the support cover plate covers a portion of the air outlets or covers no air outlets when being in the folded state and the mobile terminal is in the low-power consumption state, the support cover plate covers the first surface of the heat-dissipating housing and blocks a portion of the first air inlets, and some other of the first air inlets may be exposed. The heat-dissipating fan operating at low rotational speed may direct external air into the air duct through a portion of the first air inlets to dissipate heat for the heat-generating component, and then direct the air out through the air outlets.

For another example, the fixed housing includes a third side surface and a fourth side surface, and the third side surface may be disposed opposite to the fourth side surface. The foregoing mobile terminal further includes a plurality of second air inlets, and the plurality of second air inlets may be distributed on the third side surface and the fourth side surface, which has little impact on the minimalist design and refinement of the appearance of the mobile terminal. When the mobile terminal is in the low-power consumption state and the mobile terminal is in the low-power consumption state, the heat-dissipating fan operating at low rotational speed may direct external air into the air duct through the plurality of second air inlets in the fixed housing, dissipate heat for the heat-generating component, and then direct the air out through the air outlets.

There may also be a plurality of distribution manners of the plurality of air outlets in the housing. In some embodiments, the support cover plate covers only a partial region of the first surface of the heat-dissipating housing. The plurality of air outlets may be distributed on the first surface of the heat-dissipating housing, and a portion of the air outlets are located in a region that is on the first surface and that is not blocked by the support cover plate.

In some other embodiments, the support cover plate may cover the entire first surface of the heat-dissipating housing. A portion of the plurality of air outlets is distributed on the first surface of the heat-dissipating housing, and the remainder of the plurality of air outlets are distributed on the first side surface and the second side surface of the heat-dissipating housing separately. When the mobile terminal is in the low-power consumption state, the heat-exchanged air may be directed out through the air outlets in the first side surface and the second side surface, and an air outlet area is large, thereby facilitating heat dissipation with low power consumption. In addition, the minimalist design and refinement of the appearance of the mobile terminal can be achieved.

Alternatively, in some other embodiments of this application, the fixed housing includes a fifth side surface, and the fifth side surface may be located between the third side surface and the fourth side surface. A portion of the plurality of air outlets is distributed on the first surface of the heat-dissipating housing, and the remainder of the plurality of air outlets are distributed on the fifth side surface of the fixed housing. When the mobile terminal is in the low-power consumption state, the heat-exchanged air may be directed out through the air outlets in the fifth side surface, and an air outlet area is large, thereby facilitating heat dissipation with low power consumption. In addition, the minimalist design and refinement of the appearance of the mobile terminal can also be achieved.

According to a second aspect, an embodiment of this application further includes a heat dissipation control method of the foregoing mobile terminal. The heat dissipation control method includes: obtaining a current status of the support cover plate. The current status of the support cover plate may be a folded state or an unfolded state. On or off of the heat-dissipating apparatus is controlled or operating power of the heat-dissipating apparatus is adjusted (for example, if the heat-dissipating apparatus is a heat-dissipating fan, rotational speed of the heat-dissipating fan is adjusted) based on the current status of the support cover plate. Therefore, according to the heat dissipation control method, different states of the support cover plate in the mobile terminal may be switched in different power consumption states, to switch between different heat dissipation manners, thereby ensuring that the mobile terminal has a good heat dissipation effect in both a high-power consumption state and a low-power consumption state. In addition, for the mobile terminal, minimalist design and refinement of appearance of the mobile terminal can be achieved.

### BRIEF DESCRIPTION OF DRAWINGS

To describe technical solutions in embodiments of this application, the following describes accompanying drawings used in embodiments of this application.
FIG. 1 is a diagram 1 of a three-dimensional structure of a tablet computer according to an embodiment of this application;
FIG. 2 is a diagram of a structure of a tablet computer with a housing removed according to an embodiment of this application;
FIG. 3 is a diagram 2 of a three-dimensional structure of a tablet computer according to an embodiment of this application;
FIG. 4 is a diagram 1 of a structure of a tablet computer with a support cover plate removed according to an embodiment of this application;
FIG. 5a is a diagram of a three-dimensional structure of a tablet computer in an unfolded state according to an embodiment of this application;
FIG. 5b is a three-dimensional diagram of a third tablet computer according to an embodiment of this application;
FIG. 6 is a diagram 2 of a structure of a tablet computer with a support cover plate removed according to an embodiment of this application;
FIG. 7a is a rear view of a first tablet computer according to an embodiment of this application;
FIG. 7b is a diagram of air outlet of the first tablet computer when a support cover plate is in an unfolded state according to an embodiment of this application;
FIG. 8a is a three-dimensional diagram of a second tablet computer according to an embodiment of this application;
FIG. 8b is a diagram of air outlet of the second tablet computer when a support cover plate is in an unfolded state according to an embodiment of this application;
FIG. 9a is a diagram of a structure of a tablet computer with a heat-conducting apparatus according to an embodiment of this application;
FIG. 9b is a diagram of a structure of a tablet computer with a heat-spreading apparatus according to an embodiment of this application;
FIG. 10 is a diagram of assembly of a driving member, a hinge shaft, and a support cover plate in a tablet computer according to an embodiment of this application;
FIG. 11a is a side view of a housing of a tablet computer according to an embodiment of this application;
FIG. 11b is an enlarged view of a position A in FIG. 11a;
FIG. 12 is a partial enlarged view of a housing with a detection apparatus according to an embodiment of this application;
FIG. 13 is a diagram of a structure of a fourth tablet computer with a support cover plate removed according to an embodiment of this application;
FIG. 14a is a diagram of a structure of the fourth tablet computer in a folded state according to an embodiment of this application;
FIG. 14b is a diagram of a structure of the fourth tablet computer in an unfolded state according to an embodiment of this application;
FIG. 15 is a diagram of a structure of a fifth tablet computer according to an embodiment of this application;
FIG. 16a is a diagram of a structure of the fifth tablet computer in a folded state according to an embodiment of this application;
FIG. 16b is a diagram of a structure of the fifth tablet computer in an unfolded state according to an embodiment of this application;
FIG. 17 is a diagram of a structure of a sixth tablet computer with a support cover plate removed according to an embodiment of this application;
FIG. 18a is a diagram of a structure of the sixth tablet computer with a first support cover plate according to an embodiment of this application;
FIG. 18b is a diagram of a structure of the sixth tablet computer with a second support cover plate according to an embodiment of this application; and
FIG. 19 is a schematic flowchart of a heat dissipation control method of a tablet computer according to an embodiment of this application.

Reference numerals:
1000-tablet computer; 100-housing; 1-fixed housing; 11-third side surface; 12-fourth side surface; 13-fifth side surface; 2-heat-dissipating housing; 21-first side surface; 22-second side surface; 23-first surface; 3-support cover plate; 101-first air inlet; 102-air outlet; 103-second air inlet; 4-hinge shaft; 200-display panel; 201-non-display surface; 300-mainboard; 400-electronic component; 400A-heat-generating component; 401-central processing unit; 402-battery; 500-heat-dissipating apparatus; 600-heat-conducting apparatus; 700-heat-spreading apparatus; 800-driving member; 900-detection apparatus.

### DESCRIPTION OF EMBODIMENTS

To make the objectives, technical solutions, and advantages of this application clearer, the following further describes this application in detail with reference to the accompanying drawings.

The terms "first" and "second" mentioned below are merely intended for a purpose of description, and shall not be understood as an indication or implication of relative importance or implicit indication of the quantity of indicated technical features. Therefore, a feature limited by "first", "second", or the like may explicitly or implicitly include one or more features. In the descriptions of this application, unless otherwise stated, "a plurality of" means two or more than two.

In addition, in this application, orientation terms such as "upper", "lower", "left", "right", "horizontal", and "vertical" are defined relative to an orientation in which components are schematically placed in the accompanying drawings. It should be understood that, these directional terms are relative concepts that are used for relative description and clarification, and may vary accordingly based on a change of the orientation in which the components are placed in the accompanying drawings.

In this application, unless otherwise specified and limited, the term "connection" should be understood in a broad sense. For example, the term "connection" may be a connection of a mechanical structure or a connection of a physical structure. For example, the connection may be a fixed connection, or may be a detachable connection, or may be an integrated connection, or may be a direct connection, or may be an indirect connection through an intermediate medium. The connection may alternatively be understood that components are in physical contact and electrically conductive, or may be understood that different components in a line structure are connected through a physical line that can transmit an electrical signal, such as a PCB copper foil or a conducting wire.

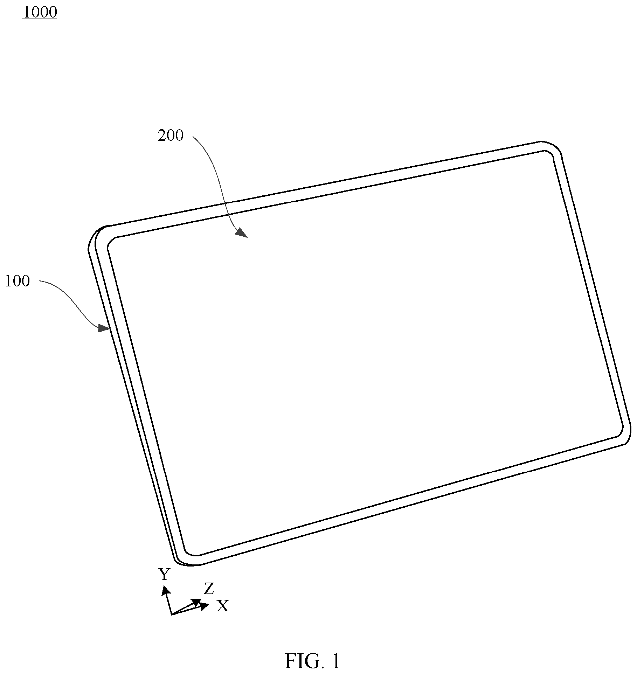

This application provides a mobile terminal. The mobile terminal may include devices such as a mobile phone, a tablet computer (tablet computer), a laptop computer (laptop computer), a personal digital assistant (personal digital assistant, PDA), a personal computer, and a notebook computer. A specific form of the foregoing mobile terminal is not specifically limited in embodiments of this application. For ease of description, the following uses an example in which the mobile terminal is a tablet computer shown in FIG. 1 for description.

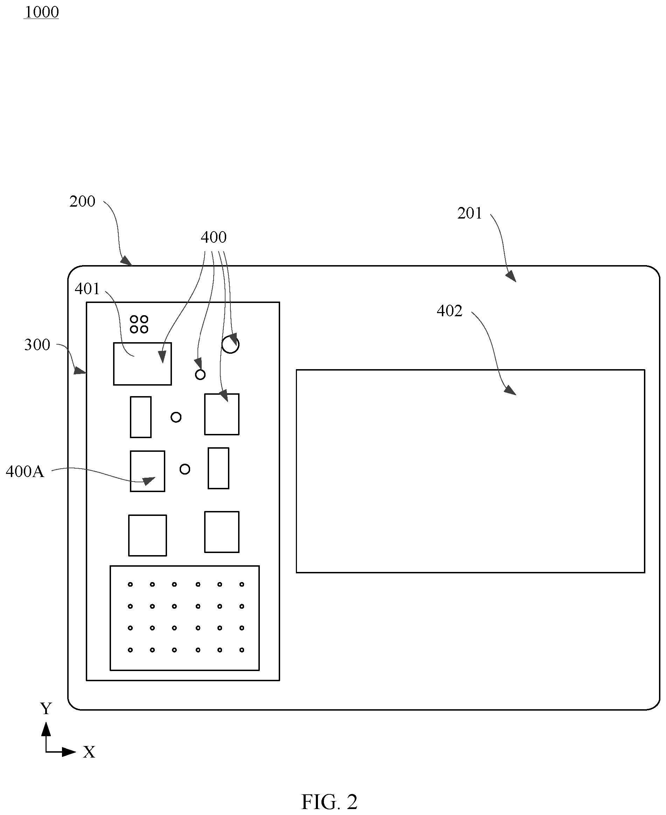

FIG. 1 is a three-dimensional diagram of a tablet computer according to some embodiments of this application, and FIG. 2 is a diagram of a structure of some components of the tablet computer shown in FIG. 1. It can be learned from the foregoing that, in this embodiment, an electronic device is a tablet computer 1000. The tablet computer 1000 may include a housing 100, a display panel 200, a mainboard 300, and a battery 402 that are shown in FIG. 1 and FIG. 2. The housing 100 is snapped on a side of a non-display surface 201 of the display panel 200, and forms a mounting cavity (not shown in the figure). The mainboard 300 may be fastened in the mounting cavity of the housing 100. Various electronic components 400 may be disposed on the mainboard 300, for example, a central processing unit 401 (namely, a processing chip), a memory card, an audio card, a network interface card, and various interfaces. The battery 402 is electrically connected to the mainboard 300.

It may be understood that FIG. 1 and FIG. 2 only schematically show some other components further included in the tablet computer 1000. Actual shapes, actual sizes, actual positions, and actual structures of these components are not limited by FIG. 1 and FIG. 2. In some other examples, the tablet computer 1000 may further include a camera, a microphone, an earpiece, and the like.

Because the battery 402 in the tablet computer 1000 and the various electronic components 400 on the mainboard 300 generate much heat during operation in a high-power consumption mode, in other words, the battery 402 and the various electronic components 400 are both heat-generating components 400A, the tablet computer 1000 needs to have good heat dissipation performance. If a plurality of air inlets and a plurality of air outlets are provided in the housing 100, although the tablet computer 1000 can have good heat dissipation performance, minimalist design and refinement of appearance of the tablet computer 1000 are affected.

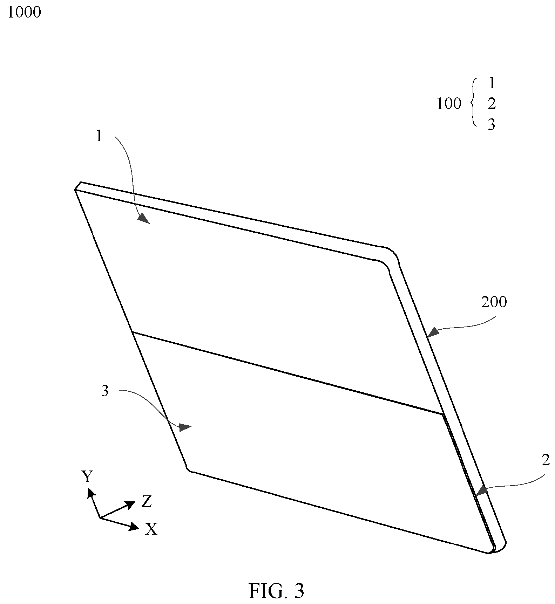

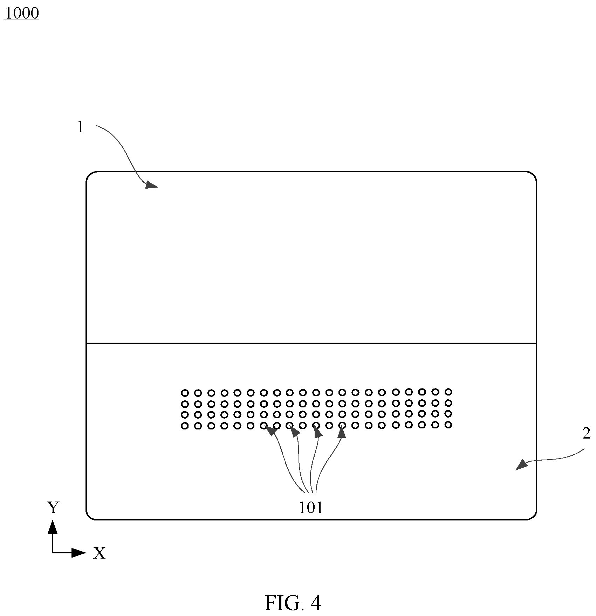

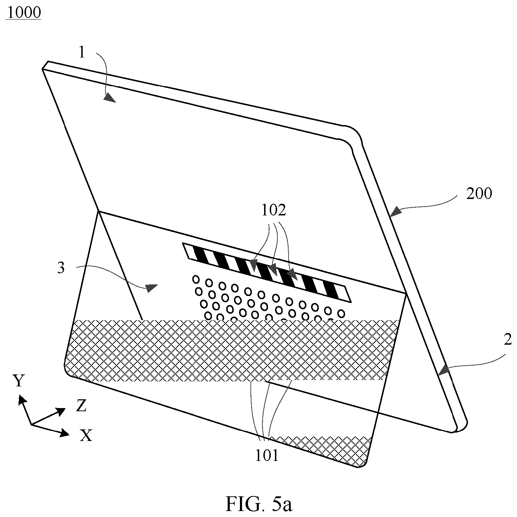

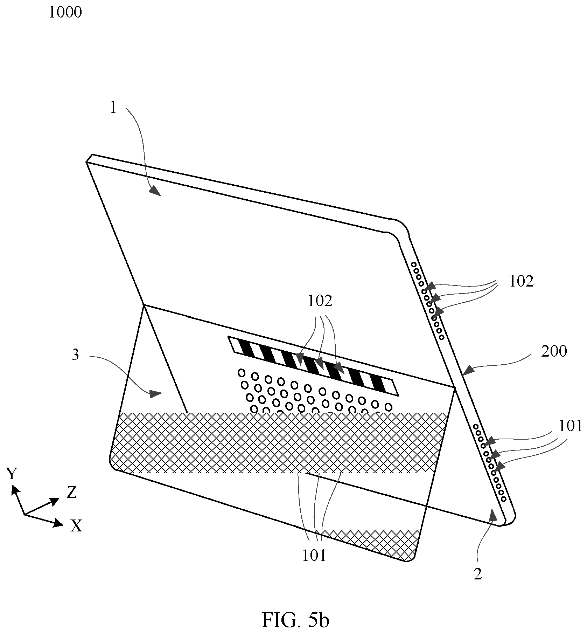

To resolve this problem, an embodiment of this application provides a tablet computer 1000 with an improved structure. Refer to FIG. 3. A housing 100 in the tablet computer 1000 includes a fixed housing 1, a heat-dissipating housing 2, and a support cover plate 3. The fixed housing 1 and the heat-dissipating housing 2 are connected and disposed (for example, snapped) on a side of a non-display surface 201 of a display panel 200. In addition, the display panel 200, the fixed housing 1, and the heat-dissipating housing 2 may define the foregoing mounting cavity. The fixed housing 1 and the heat-dissipating housing 2 may be specifically of an integrated structure, or fastened in a manner such as welding. The housing 100 is provided with a plurality of first air inlets 101 shown in FIG. 4 and a plurality of air outlets 102 shown in FIG. 5a and FIG. 5b. The plurality of first air inlets 101 are located in the heat-dissipating housing 2. The plurality of air outlets 102 may be located in the fixed housing 1, or may be located in the heat-dissipating housing 2, or may be located in the fixed housing 1 and the heat-dissipating housing 2 separately. The plurality of air outlets 102 shown in FIG. 5a are all located in the heat-dissipating housing 2. The plurality of air outlets 102 shown in FIG. 5b are disposed in the heat-dissipating housing 2 and the fixed housing separately. The support cover plate 3 is disposed on a side of the heat-dissipating housing 2 away from the display panel 200.

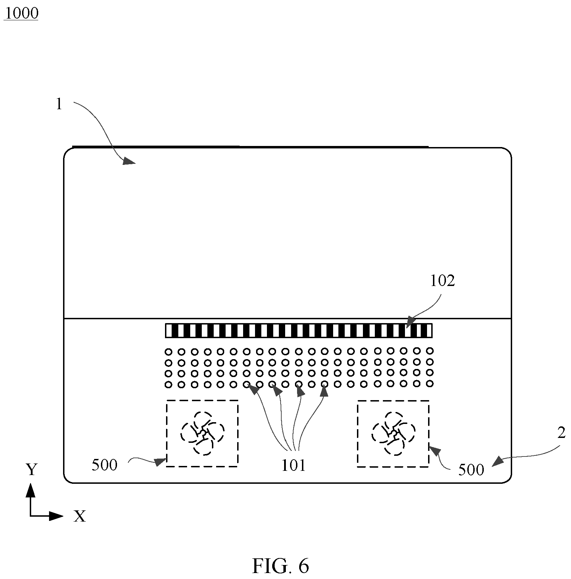

The tablet computer 1000 further includes an air duct (not shown in the figure) and a heat-dissipating apparatus 500 shown in FIG. 6. The air duct is disposed in the mounting cavity of the housing 100, and communicates the plurality of first air inlets 101 with the air outlets 102. A heat-generating component 400A is disposed in the air duct. The heat-dissipating apparatus 500 is disposed in the mounting cavity, and may be specifically a heat-dissipating fan shown in FIG. 6. The heat-dissipating apparatus 500 may direct external air to the heat-generating component 400A in the air duct through the plurality of first air inlets 101 for heat exchange, and then direct the heat-exchanged air out through the plurality of air outlets 102. In addition, the support cover plate 3 is movably connected to the heat-dissipating housing 2, or the support cover plate 3 is movably connected to the fixed housing 1. Alternatively, the support cover plate 3 is movably connected to both the heat-dissipating housing 2 and the fixed housing 1. The support cover plate 3 is movable or rotatable relative to the heat-dissipating housing 2. Therefore, the support cover plate 3 may have different states. For example, the support cover plate 3 has a folded state shown in FIG. 3 and an unfolded state shown in FIG. 5a and FIG. 5b. The folded state is that the support cover plate 3 covers the heat-dissipating housing 2 and can block some or all or all of the first air inlets 101 in the heat-dissipating housing 2. The unfolded state is that the support cover plate 3 supports the display panel 200 in an upright position and is moved away from the blocked first air inlets 101. When moving or rotating relative to the heat-dissipating housing 2, the support cover plate 3 may switch between the folded state and the unfolded state. The support cover plate 3 supports the display panel 200 in the upright position, thereby facilitating viewing of the display panel 200.

It should be noted that when the support cover plate 3 switches to the folded state, the tablet computer 1000 may be in a low-power consumption state. When the support cover plate 3 switches to the unfolded state, the tablet computer 1000 may be in a high-power consumption state. Alternatively, when the tablet computer 1000 is in the low-power consumption state, the support cover plate 3 may switch to the folded state. When the tablet computer 1000 is in the high-power consumption state, the support cover plate 3 switches to the unfolded state.

Compared with the existing technology, in this embodiment of this application, a portion of the housing 100 of the tablet computer 1000 is changed into the heat-dissipating housing 2 and the support cover plate 3, and the heat-dissipating housing 2 and the fixed housing 1 are connected to form an integrated structure and disposed on a non-display side of the display panel 200, to form the mounting cavity. Various heat-generating components 400A, the heat-dissipating apparatus 500, and the air duct may be accommodated in the mounting cavity to implement a function of the original housing 100. The plurality of first air inlets 101 provided in the heat-dissipating housing 2 are in communication with the plurality of air outlets 102 through the air ducts in the housing 100. The support cover plate 3 is movably connected to either or both of the heat-dissipating housing 2 and the fixed housing 1. When the support cover plate 3 moves or rotates relative to either or both of the heat-dissipating housing 2 and the fixed housing 1, the support cover plate 3 switches between the folded state and the unfolded state. When the tablet computer 100 is in the high-power consumption state, the support cover plate 3 switches to the unfolded state. In this case, the support cover plate 3 supports the display panel 200 in an upright position and is moved away from the plurality of blocked first air inlets 101. Therefore, the heat-dissipating apparatus 500 may direct external air to enter the air duct of the housing 100 through the plurality of first air inlets 101 for heat exchange with the heat-generating component 400A in the air duct, and then direct the air out of the air duct through the plurality of air outlets 102. The heat-dissipating apparatus 500 may perform forced and efficient heat dissipation on the heat-generating component 400A, and heat dissipation performance for the heat-generating component 400A is good. When the tablet computer 100 is in the low-power consumption state, the support cover plate 3 switches to the folded state. In this case, the support cover plate 3 covers the heat-dissipating housing 2, and blocks some or all of the first air inlets 101 in the heat-dissipating housing 2. In this case, when the support cover plate 3 blocks all the first air inlets 101 in the heat-dissipating housing 2, the tablet computer 1000 may dissipate heat for the heat-generating component 400A through natural heat exchange (heat generated by the heat-generating component 400A is conducted to the housing 100 for heat dissipation). When the support cover plate 3 blocks a portion of the first air inlets 101 in the heat-dissipating housing 2, the tablet computer 1000 may simultaneously dissipate heat for the heat-generating component 400A through natural heat exchange and the heat-dissipating apparatus 500 operating at low power. Therefore, when the support cover plate 3 is in the folded state, some or all of the first air inlets 101 are blocked, so that a small quantity of holes are provided in a surface of the tablet computer 1000, thereby improving minimalist design and refinement of an appearance of the tablet computer 1000. Therefore, the tablet computer 1000 in this embodiment of this application can achieve both the heat dissipation performance and the minimalist design and refinement of the appearance of the tablet computer 1000.

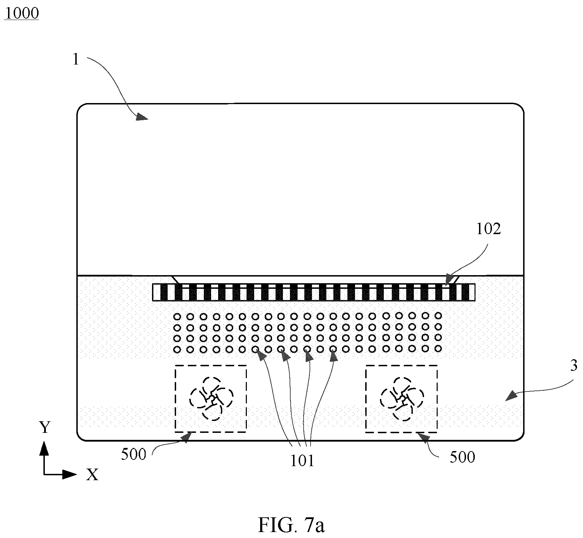

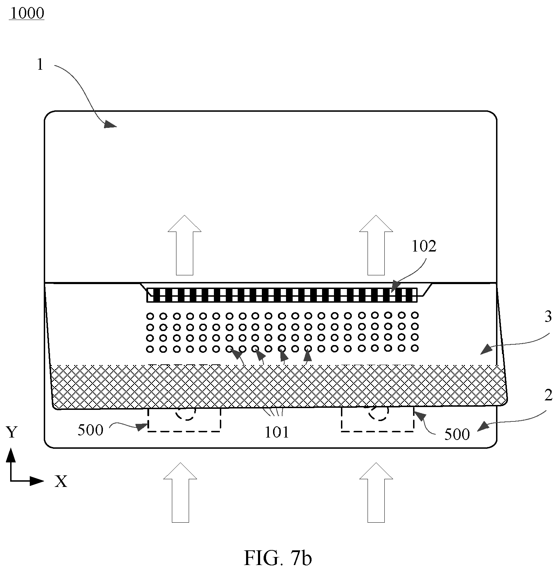

In addition, in some embodiments of this application, as shown in FIG. 7a and FIG. 7b, a portion of the plurality of air outlets 102 may be located at positions on the heat-dissipating housing 2 that are opposite to the support cover plate 3. Hollow arrows in FIG. 7b represent flow directions of air, and hollow arrows in other accompanying drawings in the following also represent the same meaning. Details are not described again in the following. Alternatively, all of the plurality of air outlets 102 may be located at the positions on the heat-dissipating housing 2 that are opposite to the support cover plate 3.

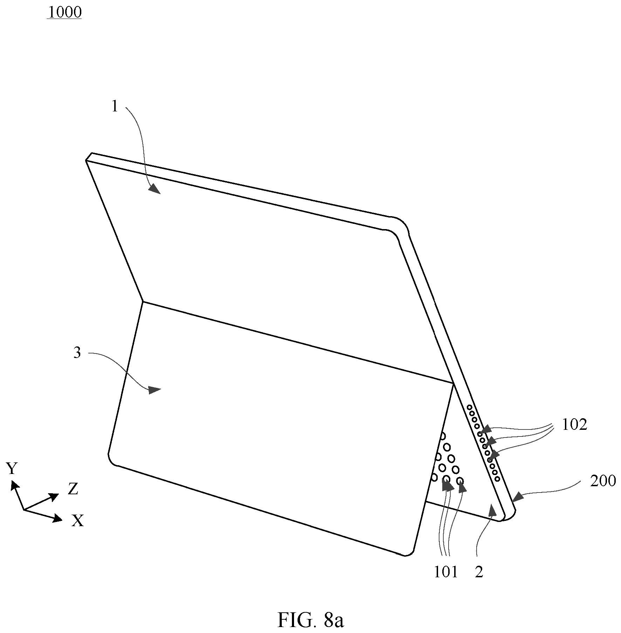

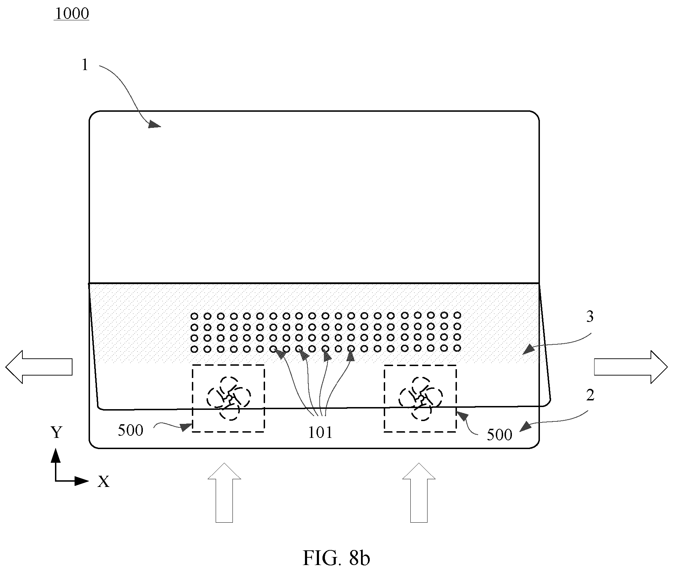

Therefore, as shown in FIG. 7a, when the support cover plate 3 is in the folded state, the support cover plate 3 may block a portion of the air outlets 102 (to be specific, some or all of the air outlets 102 that are opposite to the support cover plate 3). The plurality of air outlets 102 may be distributed on a surface of the heat-dissipating housing 2. Compared with the solution in which the plurality of air outlets 102 shown in FIG. 8a and FIG. 8b are distributed only on a side surface of the heat-dissipating housing 2, the housing 100 in this embodiment of this application shown in FIG. 7a may have a large distribution area of the air outlets 102 without affecting the minimalist design and refinement of the appearance of the tablet computer 1000. In this way, heat exchange efficiency of the tablet computer 1000 is improved.

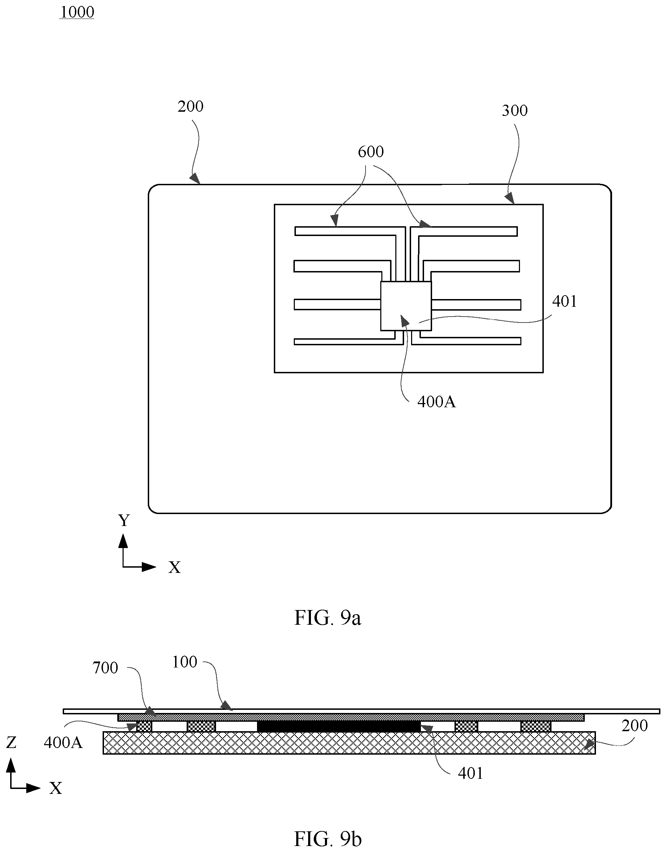

When the tablet computer 1000 is in the low-power consumption state, the heat-generating component 400A also generates heat, and therefore the tablet computer 1000 needs to have a heat dissipation function. When the plurality of air outlets 102 are blocked when the support cover plate 3 is in the folded state, to ensure the heat dissipation performance for the heat-generating component 400A, in some embodiments of this application, the foregoing tablet computer 1000 further includes a heat-conducting apparatus 600 shown in FIG. 9a. The heat-conducting apparatus 600 may be disposed in the mounting cavity and in contact with the heat-generating component 400A (for example, a central processing unit 401) and the housing 100. The contact may be direct contact, or may be contact with the housing 100 or the heat-generating component 400A through another heat-conducting medium. The heat-conducting apparatus 600 may transfer heat generated by the heat-generating component 400A to the housing 100, and then the housing 100 transfers heat to external air. Therefore, the heat-conducting apparatus 600 has fast heat conduction speed, thereby improving natural heat dissipation efficiency for the heat-generating component 400A. For example, when the tablet computer 1000 is in the low-power consumption state, the support cover plate 3 may switch to the folded state. In addition, the heat-conducting apparatus 600 can quickly conduct heat of the heat-generating component 400A to the housing 100 for heat dissipation, thereby ensuring heat dissipation performance of the tablet computer 1000. For example, the heat-conducting apparatus 600 is a heat-conducting pipe, and a heat exchange medium in the heat-conducting pipe may quickly transfer the heat of the heat-generating component 400A to the housing 100, so that heat dissipation efficiency is high.

In addition, in some implementations of this application, the foregoing tablet computer 1000 may further include a heat-spreading apparatus 700 shown in FIG. 9b, and the heat-spreading apparatus 700 is disposed in the mounting cavity and in contact with the heat-generating component 400A and the housing 100. The contact may be direct contact, or may be contact with the housing 100 and the heat-generating component 400A through another heat-conducting medium. The heat-spreading apparatus 700 may spread and move heat generated by the heat-generating component 400A in an entire plane, conduct heat from a region with high heat generation to a region with low heat generation, and conduct the heat to the housing 100 for heat dissipation. The heat-spreading apparatus 700 avoids local overheating, thereby improving a heat dissipation effect for the heat-generating component 400A. For example, when the tablet computer 1000 is in the low-power consumption state, the support cover plate 3 may switch to the folded state. In this case, the heat-spreading apparatus 700 spreads heat for the various heat-generating components 400A, thereby ensuring that no region of the tablet computer 1000 is overheated. For example, the heat-spreading apparatus 700 is a heat-spreading sheet. Alternatively, the heat-spreading apparatus 700 is a heat-spreading plate.

Based on the foregoing heat-dissipating structure, a heat dissipation manner of the tablet computer 1000 may be further designed as an automatic switching manner. That is, the tablet computer 1000 may switch between different heat dissipation manners based on different states of the support cover plate 3.

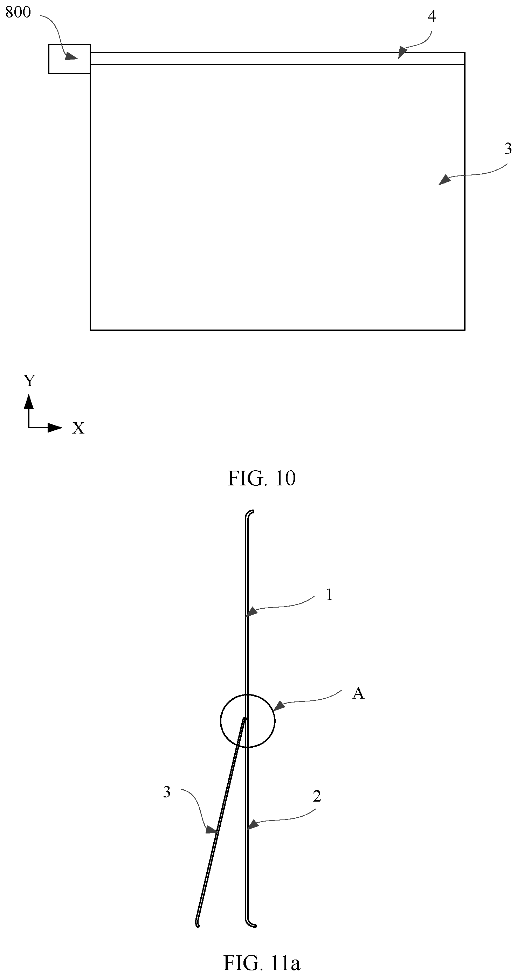

In some implementations of this application, the support cover plate 3 may be in an automatic driving manner. That is, the tablet computer 1000 further includes a driving member 800 shown in FIG. 10, and the driving member 800 is drivingly connected to the support cover plate 3. The driving member 800 may drive the support cover plate 3 to switch between the folded state and the unfolded state. In this way, automatic unfolding and folding of the support cover plate 3 are implemented.

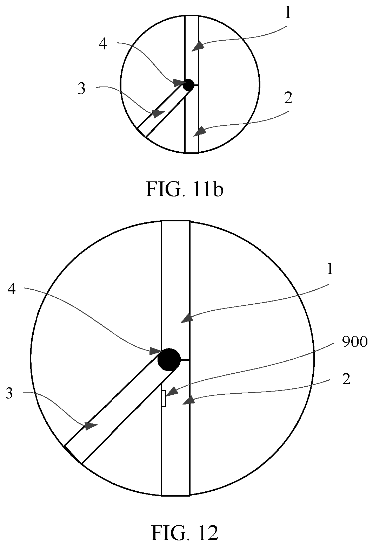

For example, as shown in FIG. 10, FIG. 11a, and FIG. 11b, the support cover plate 3 is rotatably connected to the heat-dissipating housing 2 by a hinge shaft 4. For example, the heat-dissipating housing 2 is movably fastened to the hinge shaft 4. A connection ear (not shown in the figure) is disposed on the support cover plate 3, and the connection ear is sleeved outside the hinge shaft 4 in a secured manner. The driving member 800 is specifically a driving motor. An output shaft of the driving motor is drivingly connected to the hinge shaft 4, and the driving motor drives the hinge shaft 4 to rotate, and drives the support cover plate 3 to rotate, thereby implementing automatic driving of the support cover plate 3.

In addition, the tablet computer 1000 may further include a controller, and the controller may be specifically a control circuit. The control circuit may be integrated into a central processing unit 401, or may be a separate control circuit board. This is not limited in this application. The controller is electrically connected to the driving member 800, and controls on or off of the heat-dissipating apparatus 500 or adjusts operating power of the heat-dissipating apparatus 500 based on a status of the support cover plate 3 fed back by the driving member 800.

To be specific, when the driving member 800 feeds back that the support cover plate 3 is in the folded state (for the driving motor, a motor driving plate may provide a feedback signal), the controller controls the heat-dissipating apparatus 500 to turn off, and may dissipate heat only in a natural heat dissipation manner. For example, the heat of the heat-generating component 400A is transferred to the housing 100 through the heat-dissipating apparatus 500 and the heat-spreading apparatus 700 for heat dissipation. Alternatively, the controller controls and adjusts the operating power of the heat-dissipating apparatus 500 (for example, reduces rotational speed of the heat-dissipating fan). In addition to using a natural heat dissipation manner such as the heat-dissipating apparatus 500 and the heat-spreading apparatus 700 for heat dissipation, the controller further uses the heat-dissipating fan operating at low rotational speed for forced heat dissipation. In this way, at least a portion of the first air inlets 101 and the air outlets 102 are not blocked by the support cover plate 3. When the driving member 800 feeds back that the support cover plate 3 is in the unfolded state, the heat-dissipating apparatus 500 is controlled to turn on, or the operating power of the heat-dissipating apparatus 500 is increased (for example, the rotational speed of the heat-dissipating fan is increased). In this case, none of the plurality of first air inlets 101 is blocked, and the heat-conducting apparatus 600, the heat-spreading apparatus 700, and the heat-dissipating fan operating at high rotational speed may be used to dissipate heat for the heat-generating component 400A at the same time, so that the tablet computer 1000 has high heat dissipation efficiency.

In some other implementations of this application, the support cover plate 3 may alternatively be manually driven. In other words, the status of the support cover plate 3 is manually adjusted by a user. In this case, to accurately obtain the status of the support cover plate 3, the foregoing tablet computer 1000 further includes a detection apparatus 900 shown in FIG. 12. The detection apparatus 900 may detect the status of the support cover plate 3.

For example, the detection apparatus 900 may be an angle sensor, and is mounted on the heat-dissipating housing 2 or the support cover plate 3. The detection apparatus 900 may detect an angle of the support cover plate 3 relative to the heat-dissipating housing 2. A current status of the support cover plate 3 may be determined based on an angle value detected by the detection apparatus 900.

For another example, the detection apparatus 900 may be a distance sensor, and is mounted on the heat-dissipating housing 2 or the support cover plate 3. The detection apparatus 900 may detect a distance of the support cover plate 3 relative to the heat-dissipating housing 2. The current status of the support cover plate 3 may be determined based on a distance value detected by the detection apparatus 900.

In addition, the controller is electrically connected to the detection apparatus 900. The controller may control, based on the status of the support cover plate 3 detected by the detection apparatus 900, the heat-dissipating apparatus 500 to turn on or off or adjust the operating power of the heat-dissipating apparatus 500. To be specific, when the detection apparatus 900 detects that the support cover plate 3 is in the folded state, the controller controls the heat-dissipating apparatus 500 to turn off, and may dissipate heat only in a natural heat dissipation manner. For example, the heat of the heat-generating component 400A is transferred to the housing 100 through the heat-dissipating apparatus 500 and the heat-spreading apparatus 700 for heat dissipation. Alternatively, the controller controls and adjusts the operating power of the heat-dissipating apparatus 500 (for example, reduces rotational speed of the heat-dissipating fan). In addition to using a natural heat dissipation manner such as the heat-dissipating apparatus 500 and the heat-spreading apparatus 700 for heat dissipation, the controller may use the heat-dissipating fan operating at low rotational speed for heat dissipation. In this way, at least a portion of the first air inlets 101 and the air outlets 102 are not blocked by the support cover plate 3. When the detection apparatus 900 detects that the support cover plate 3 is in the unfolded state, the controller controls the heat-dissipating apparatus 500 to turn on or increases the operating power of the heat-dissipating apparatus 500 (for example, increases the rotational speed of the heat-dissipating fan). In this case, none of the plurality of first air inlets 101 is blocked, and the heat-conducting apparatus 600, the heat-spreading apparatus 700, and the heat-dissipating fan operating at high rotational speed may be used to dissipate heat for the heat-generating component 400A at the same time, thereby achieving a good heat dissipation effect for the heat-generating component 400A.

The foregoing describes various heat-dissipating structures, auxiliary structures, and switching manners of heat dissipation manners in various tablet computers 1000. In this embodiment of this application, there may also be a plurality of distribution manners of the air inlets and the air outlets 102 of the tablet computer 1000.

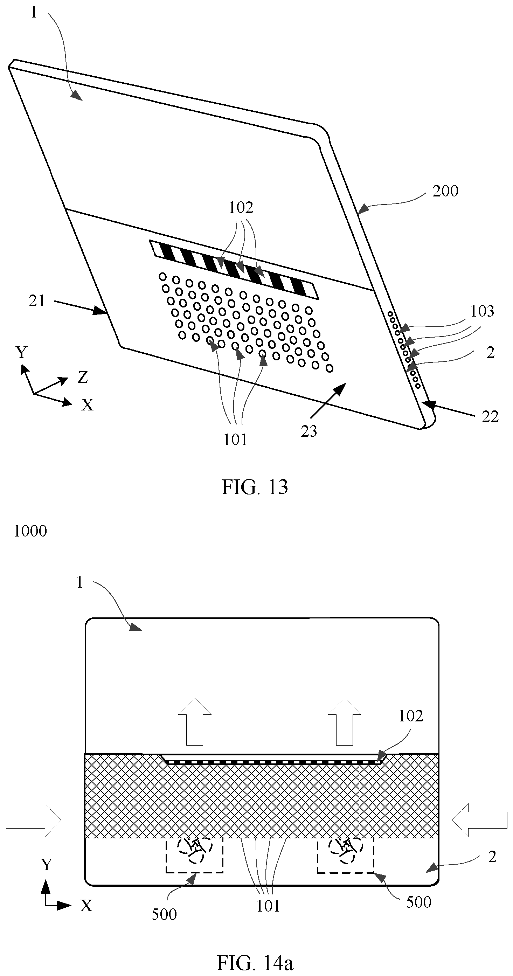

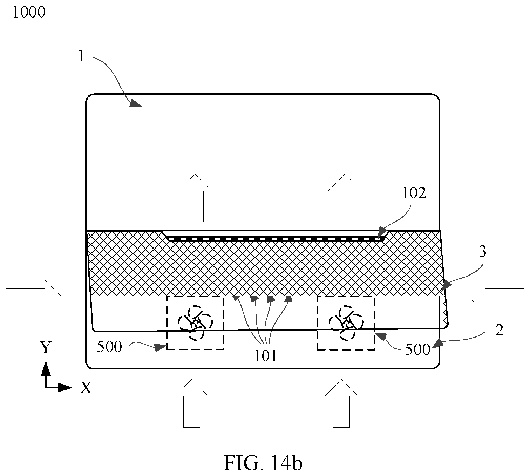

In some implementations of this application, as shown in FIG. 13, an outer surface of the heat-dissipating housing 2 includes a first side surface 21, a second side surface 22, and a first surface 23. The first side surface 21 may be disposed opposite to the second side surface 22. The support cover plate 3 covers the first surface 23. A portion of the plurality of first air inlets 101 is distributed on the first surface, and the remainder of the plurality of first air inlets 101 are distributed on the first side surface 21 and the second side surface 22 separately. When the support cover plate 3 covers a portion of the air outlets or covers no air outlets 102 when being in the folded state and the tablet computer 1000 is in the low-power consumption state, as shown in FIG. 13 and FIG. 14a, the support cover plate 3 covers the first surface 23 of the heat-dissipating housing 2 and blocks a portion of the first air inlets 101, and some other of the first air inlets 101 may be exposed. The heat-dissipating fan operating at low rotational speed may direct external air into the air duct through a portion of the first air inlets 101 to dissipate heat for the heat-generating component 400A, and then direct the air out through the air outlets 102. When the tablet computer 1000 is in the high-power consumption state, as shown in FIG. 13 and FIG. 14b, the support cover plate 3 is moved away from the heat-dissipating housing 2, and the plurality of first air inlets 101 are all exposed. The heat-dissipating fan operating at high rotational speed may direct external air into the air duct through the plurality of first air inlets 101 to dissipate heat for the heat-generating component 400A. An air inlet area of the tablet computer 1000 increases, and the heat dissipation efficiency is high.

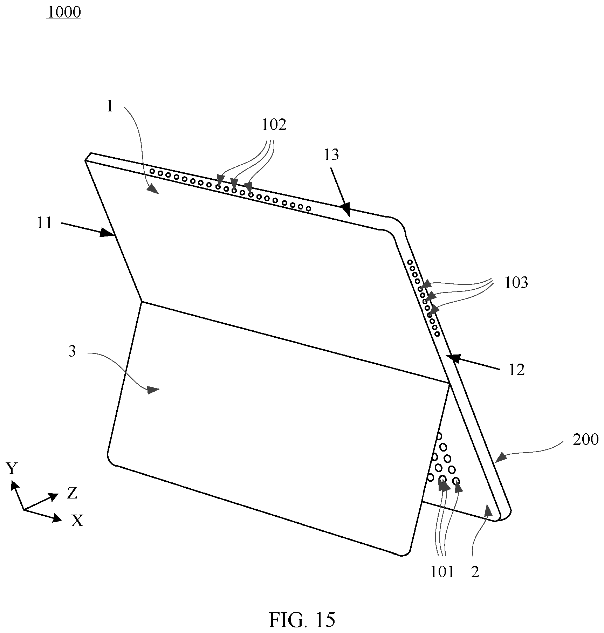

In addition, the heat dissipation efficiency for the heat-generating component 400A in the low-power consumption state may be improved by increasing the air inlet area. In some embodiments of this application, as shown in FIG. 15, the tablet computer 1000 further includes a plurality of second air inlets 103. The plurality of second air inlets 103 may be located in the fixed housing 1, and the fixed housing 1 is not blocked by the support cover plate 3. When the support cover plate 3 is in the folded state, the plurality of second air inlets 103 may be exposed, and the air inlet area is increased, thereby improving the heat dissipation efficiency for the heat-generating component 400A.

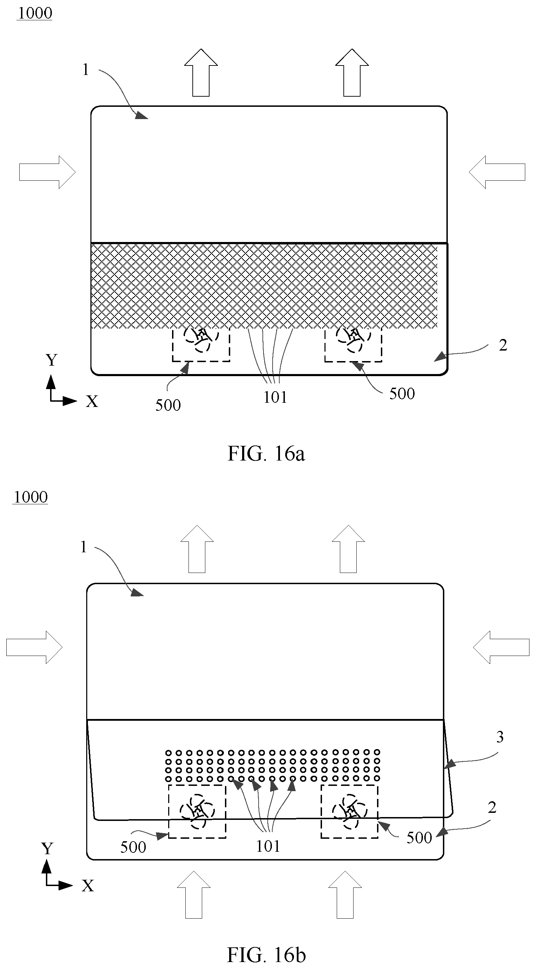

In addition, to avoid affecting the appearance of the tablet computer 1000, the fixed housing 1 includes a third side surface 11 and a fourth side surface 12, and the third side surface 11 is opposite to the fourth side surface 12. The plurality of second air inlets 103 may be distributed on the third side surface 11 and the fourth side surface 12, which has little impact on the minimalist design and refinement of the appearance of the tablet computer 1000. Therefore, when the tablet computer 1000 is in the low-power consumption state, as shown in FIG. 15 and FIG. 16a, the heat-dissipating fan operating at low rotational speed may direct external air into the air duct through the plurality of second air inlets 103 in the fixed housing 1 to dissipate heat for the heat-generating component 400A. Similarly, when the tablet computer 1000 is in the high-power consumption state, as shown in FIG. 15 and FIG. 16b, the heat-dissipating fan operating at high rotational speed may direct external air into the air duct through the plurality of first air inlets 103 and the plurality of second air inlets 103 to dissipate heat for the heat-generating component 400A. The air inl
et area of the tablet computer 1000 is increased, thereby improving the heat dissipation efficiency for the heat-generating component 400A.

The foregoing is a distribution solution of the plurality of first air inlets 101 and the plurality of second air inlets 103. There may also be a plurality of distribution manners of the plurality of air outlets 102 in the housing 100.

In some embodiments, as shown in FIG. 14a, the support cover plate 3 covers only a partial region of the first surface 23 of the heat-dissipating housing 2. The plurality of air outlets 102 may be distributed on the first surface 23 of the heat-dissipating housing 2, and a portion of the air outlets 102 are located in a region that is on the first surface 23 and that is not blocked by the support cover plate 3. Therefore, when the tablet computer 1000 is in the high-power consumption state, the area of the air outlets 102 is large, and the heat dissipation effect is good.

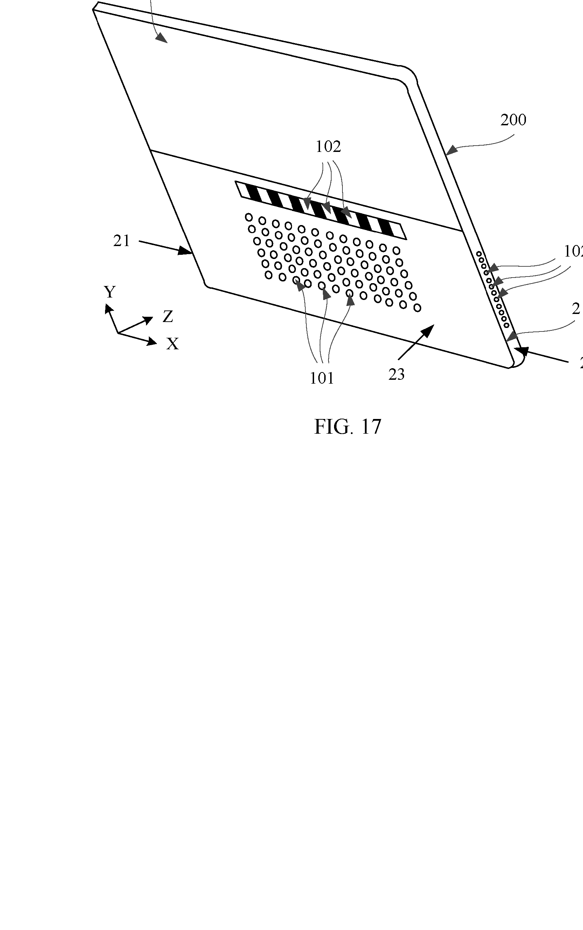

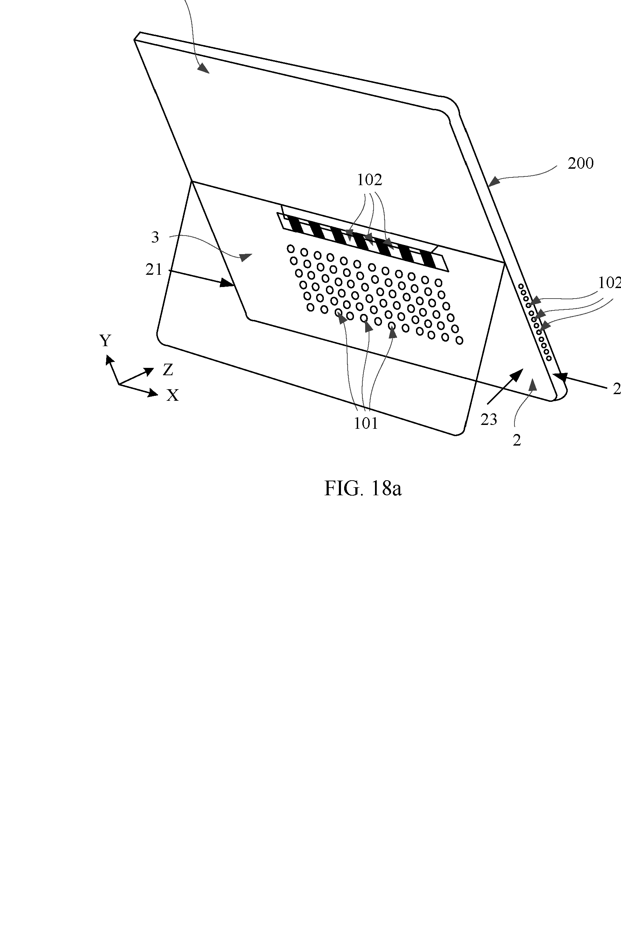

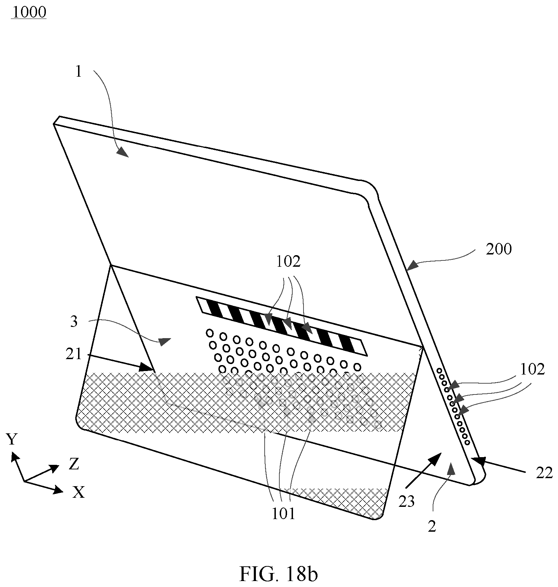

In some other embodiments, as shown in FIG. 17, a portion of the plurality of air outlets 102 is distributed on the first surface 23 of the heat-dissipating housing 2, and the remainder of the plurality of air outlets 102 are distributed on the first side surface 21 and the second side surface 22 of the heat-dissipating housing 2 separately. The distribution manner of the plurality of air outlets 102 may be applicable to a case in which the support cover plate 3 covers the entire first surface 23 of the heat-dissipating housing 2, or may be applicable to a case in which the support cover plate 3 covers a partial region of the first surface 23 of the heat-dissipating housing 2. For the latter, as shown in FIG. 18a, the plurality of air outlets 102 may be distributed on the first surface 23 of the heat-dissipating housing 2, and a portion of the air outlets 102 are located in a region that is on the first surface 23 and that is not blocked by the support cover plate 3. As shown in FIG. 18b, the plurality of air outlets 102 may be alternatively all distributed in a region that is on the heat-dissipating housing 2 and that is blocked by the support cover plate 3. This is not limited in this application.

In some other embodiments of this application, as shown in FIG. 15, the fixed housing 1 further includes a fifth side surface 13, and the fifth side surface 13 is located between the third side surface 11 and the fourth side surface 12. A portion of the plurality of air outlets 102 is distributed on the first surface 23 of the heat-dissipating housing 2, and the remainder of the plurality of air outlets 102 are distributed on the fifth side surface 13 of the fixed housing 1. When the tablet computer 1000 is in the low-power consumption state, an air outlet area is also large, which facilitates heat dissipation with low power consumption. In addition, the minimalist design and refinement of the appearance of the tablet computer 1000 can also be achieved.

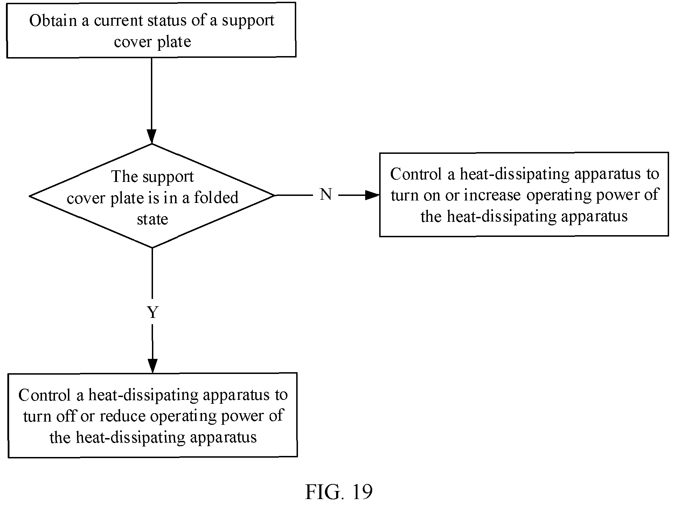

Based on the structure of the foregoing tablet computer 1000, an embodiment of this application further provides a heat dissipation control method of the tablet computer 1000. Refer to FIG. 19, the heat dissipation control method includes the following steps.

S100: Obtain a current status of the support cover plate 3. The current status of the support cover plate 3 is a folded state or an unfolded state.

S200: Control on or off of the heat-dissipating apparatus 500 or adjust operating power of the heat-dissipating apparatus 500 (for example, if the heat-dissipating apparatus 500 is a heat-dissipating fan, adjust rotational speed of the heat-dissipating fan) based on the current status of the support cover plate 3.

In other words, when the support cover plate 3 is in the folded state, the controller controls the heat-dissipating apparatus 500 to turn off or reduces the operating power of the heat-dissipating apparatus 500. When the support cover plate 3 is in the unfolded state, the controller controls the heat-dissipating apparatus 500 to turn on or increases the operating power of the heat-dissipating apparatus 500.

Therefore, according to the heat dissipation control method, different states of the support cover plate 3 in the tablet computer 1000 may be switched in different power consumption states, to switch between different heat dissipation manners, thereby ensuring that the tablet computer 1000 has a good heat dissipation effect in both a high-power consumption state and a low-power consumption state. In addition, for the tablet computer 1000, the minimalist design and refinement of the appearance of the tablet computer 1000 can also be achieved.

The foregoing descriptions are merely specific implementations of this application, but are not intended to limit the scope of protection of this application. Any variation or replacement readily figured out by a person skilled in the art within the technical scope disclosed in this application shall fall within the scope of protection of this application. Therefore, the scope of protection of this application shall be subject to the scope of protection of the claims.

## Claims

1. A mobile terminal, comprising:
a display panel, a heat-generating component, and a heat-dissipating apparatus;
a housing, wherein the housing comprises a fixed housing, a heat-dissipating housing, and a support cover plate, and the fixed housing and the heat-dissipating housing are connected and disposed on a non-display side of the display panel to define a mounting cavity; a plurality of first air inlets are provided in the heat-dissipating housing, and a plurality of air outlets are provided in the fixed housing and/or the heat-dissipating housing; and the support cover plate is disposed on a side of the heat-dissipating housing away from the display panel; and
an air duct, wherein the air duct and the heat-dissipating apparatus are disposed in the mounting cavity, and the air duct communicates the plurality of first air inlets with the air outlets; the heat-generating component is disposed in the air duct; and the heat-dissipating apparatus is configured to direct external air to the heat-generating component in the air duct through the plurality of first air inlets for heat exchange, and then direct the heat-exchanged air out through the plurality of air outlets, wherein
the support cover plate is movably connected to the heat-dissipating housing and/or the fixed housing; the support cover plate switches between a folded state and an unfolded state; the folded state is that the support cover plate covers the heat-dissipating housing and blocks at least a portion of the first air inlets; and the unfolded state is that the support cover plate supports the display panel in an upright position and is moved away from the at least a portion of the first air inlets.

2. The mobile terminal according to claim 1, wherein at least a portion of the plurality of air outlets is located at positions on the heat-dissipating housing that are opposite to the support cover plate; and when the support cover plate is in the folded state, the support cover plate blocks the at least a portion of the air outlets.

3. The mobile terminal according to claim 1 or 2, wherein the mobile terminal further comprises:
a heat-conducting apparatus, wherein the heat-conducting apparatus is disposed in the mounting cavity and in contact with the heat-generating component and the housing separately.

4. The mobile terminal according to any one of claims 1 to 3, wherein the mobile terminal further comprises:
a heat-spreading apparatus, wherein the heat-spreading apparatus is disposed in the mounting cavity and in contact with the heat-generating component and the housing separately.

5. The mobile terminal according to any one of claims 1 to 4, wherein the mobile terminal further comprises:
a driving member, wherein the driving member is drivingly connected to the support cover plate and configured to drive the support cover plate to switch between the folded state and the unfolded state; and
a controller, wherein the controller is electrically connected to the driving member; and the controller is configured to: when the driving member feeds back that the support cover plate is in the folded state, control the heat-dissipating apparatus to turn off or reduce operating power of the heat-dissipating apparatus; or when the driving member feeds back that the support cover plate is in the unfolded state, control the heat-dissipating apparatus to turn on or increase operating power of the heat-dissipating apparatus.

6. The mobile terminal according to any one of claims 1 to 4, wherein the mobile terminal further comprises:
a detection apparatus, wherein the detection apparatus is configured to detect a status of the support cover plate; and
a controller, wherein the controller is electrically connected to the heat-dissipating apparatus and the detection apparatus, and the controller is configured to: when the detection apparatus detects that the support cover plate is in the folded state, control the heat-dissipating apparatus to turn off or reduce operating power of the heat-dissipating apparatus; and when the detection apparatus detects that the support cover plate is in the unfolded state, control the heat-dissipating apparatus to turn on or increase operating power of the heat-dissipating apparatus.

7. The mobile terminal according to any one of claims 1 to 6, wherein the heat-dissipating housing comprises a first surface, a first side surface, and a second side surface, and the support cover plate covers the first surface; a portion of the plurality of first air inlets is distributed on the first surface; and the remainder of the plurality of first air inlets are distributed on the first side surface and the second side surface.

8. The mobile terminal according to any one of claims 1 to 6, wherein the fixed housing comprises a third side surface and a fourth side surface; and the mobile terminal further comprises:
a plurality of second air inlets, wherein the plurality of second air inlets are distributed on the third side surface and the fourth side surface of the fixed housing.

9. The mobile terminal according to any one of claims 1 to 8, wherein the heat-dissipating housing comprises a first surface, a first side surface, and a second side surface; the support cover plate covers a partial region of the first surface; and the plurality of air outlets are distributed on the first surface, and a portion of the air outlets are distributed on a region that is on the first surface and that is not blocked by the support cover plate; or
a portion of the plurality of air outlets is distributed on the first surface, and the remainder of the plurality of air outlets are distributed on the first side surface and the second side surface separately.

10. The mobile terminal according to any one of claims 1 to 8, wherein the heat-dissipating housing comprises a first surface, and the support cover plate covers the first surface; a portion of the plurality of air outlets is distributed on the first surface; and the fixed housing comprises a fifth side surface, and the remainder of the plurality of air outlets are distributed on the fifth side surface.

11. A heat dissipation control method of the mobile terminal according to any one of claims 1 to 10, comprising:
obtaining a current status of the support cover plate; and
controlling on or off of the heat-dissipating apparatus or adjusting operating power of the heat-dissipating apparatus based on the current status of the support cover plate.
